# EUROPÄISCHE PATENTSCHRIFT

(11) **EP 0 834 217 B1**
(45) Veröffentlichungstag und Bekanntmachung des Hinweises auf die Patenterteilung: **30.01.2002**
(21) Anmeldenummer: 97907021.6
(22) Anmeldetag: 28.01.1997
(51) Int. Cl.: H03G 3/30

(54) **VERFAHREN ZUR STEUERUNG DER LEISTUNG EINES SENDEVERSTÄRKERS EINES FUNKGERÄTES**
PROCESS FOR CONTROLLING THE POWER OF THE TRANSMISSION AMPLIFIER OF RADIO EQUIPMENT
PROCEDE DE REGULATION DE LA PUISSANCE DE L'AMPLIFICATEUR D'EMISSION D'UN APPAREIL RADIO

(30) Priorität: 20.04.1996 DE 19615842
(43) Veröffentlichungstag der Anmeldung: 08.04.1998
(73) Patentinhaber: ROBERT BOSCH GMBH, 70442 Stuttgart (DE)
(72) Erfinder: SCHOLZ, Matthias, D-38642 Goslar (DE)
(74) Vertreter: Friedmann, Jürgen, Dr.-Ing.
(86) Internationale Anmeldenummer: DE9700142
(87) Internationale Veröffentlichungsnummer: WO9740577

(56) Entgegenhaltungen:
- EP-A- 0 412 392
- EP-A- 0 561 754
- EP-A- 0 667 675
- US-A- 5 426 641

## Beschreibung

### Stand der Technik

Die Erfindung geht von einem Verfahren zur Steuerung der Leistung eines Sendeverstärkers eines Funkgerätes, insbesondere des Sendeverstärkers eines Mobilfunk-Telefons, über einen Digital-Analog-Wandler nach der Gattung des Hauptanspruchs aus.

Aus "European digital cellular telecommunications system" (Phase 2); Radio transmission und reception (GSM 05.05) "des European Telecommunications Standards Institute vom Mai 1994 ist bekannt, daß bei Mobilfunk-Telefonen Daten im Zeitlagenmultiplex übertragen werden, d. h. daß Sendevorgänge nur während bestimmter Zeitschlitze in sogenannten "Bursts" erfolgen. Dabei wird die Leistung des Sendeverstärkers nur für den eigentlichen Sendevorgang nach einer vorgegebenen Zeitfunktion auf den erforderlichen Wert erhöht. Sowohl für den zeitlichen Verlauf als auch für den Endwert der Sendeleistung ist dabei ein enger Toleranzbereich vorgeschrieben, so daß an den Digital-Analog-Wandler, über den die Leistung des Sendeverstärkers gesteuert wird, hohe Anforderungen hinsichtlich Genauigkeit und Offset-Freiheit gestellt werden.

### Vorteile der Erfindung

Das erfindungsgemäße Verfahren ermöglicht dem gegenüber eine präzise Steuerung der Leistung des Sendeverstärkers eines Funkgeräts über herkömmliche Digital-Analog-Wandler, an die keine besonderen Anforderungen hinsichtlich ihrer Offset-Freiheit gestellt werden. Dies wird in vorteilhafter Weise dadurch erreicht, daß der Offset des Digital-Analog-Wandlers in Sendepausen gemessen und beim darauffolgenden Sendevorgang bei der Ansteuerung des Digital-Analog-Wandlers als Korrekturgröße berücksichtigt wird.

Weiterhin ist es vorteilhaft, das in Sendepausen im Rahmen von Prüfzyklen vom Digital-Analog-Wandler abgegebene Signal vor der Auswertung zu verstärken, so daß insbesondere für kleine Werte des Offsets eine hohe Auflösung bei dessen Bestimmung erreicht wird. Zudem kann dadurch eine Verfälschung bei der Bestimmung des Offsets durch einen zusätzlichen Offset des Analog-Digital-Wandlers zur Rückwandlung des analogen in ein digitales Signal weitgehend vernachlässigt werden.

Schließlich ist es von Vorteil, wenn die Offsets der an der Ermittlung des Offsets des Digital-Analog-Wandlers beteiligten Schaltungsstufen bekannt sind, so daß diese Verfälschungen in Form von Korrekturwerten berücksichtigt werden können.

Ist der Offset des Digital-Analog-Wandlers im wesentlichen von der Umgebungstemperatur abhängig, so kann der Wert des Offsets weiterhin zur Kompensation des Temperaturgangs weiterer Bauelemente verwendet werden.

### Zeichnung

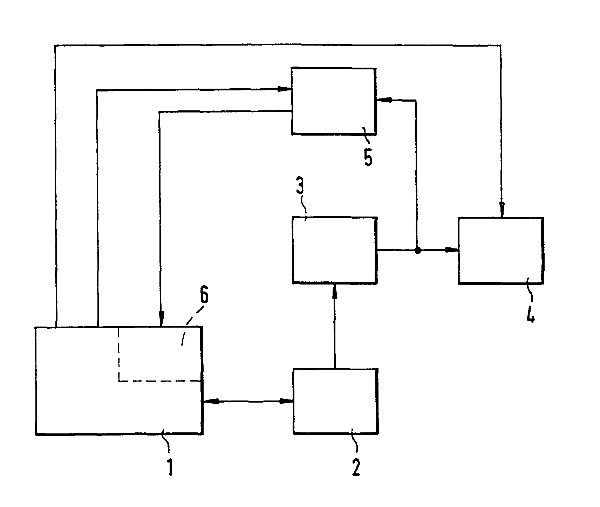

Ein Ausführungsbeispiel der Erfindung ist in der Zeichnung dargestellt und in der nachfolgenden Beschreibung näher erläutert. Die Figur zeigt schematisch eine Anordung zur Durchführung des erfindungsgemäßen Verfahrens, wobei zur Vereinfachung nur die für die Erfindung wesentlichen Funktionsblöcke dargestellt sind.

### Beschreibung

Das erfindungsgemäße Verfahren wird im folgenden am Beispiel von nach dem GSM-Standard betriebenen Mobilfunk-Telefonen geschrieben, ist jedoch prinzipiell nicht auf diesen Anwendungsfall beschränkt, sondern läßt sich auch allgemein auf Funkgeräte ausweiten.

Bei dem in der Figur dargestellten Ausführungsbeispiel einer Schaltungsanordnung zur Durchführung des erfindungsgemäßen Verfahrens ist eine Auswerte- und Steuereinheit 1 über eine Datenleitung mit einem Signalgenerator 2 verbunden. Der Signalgenerator 2 steuert den Digital-Analog-Wandler 3 an, dessen Ausgangssignal zum einen dem Sendeverstärker 4, zum anderen einem Verstärker 5 zugeführt ist, der wiederum mit einem der Auswerte- und Steuereinheit 1 zugeordneten Analog-Digital-Wandler verbunden ist. Darüberhinaus ist dem Verstärker 5 von der Auswerte- und Steuereinheit 1 ein Stellsignal zur Einstellung seiner Verstärkung zugeführt. Des weiteren ist dem Sendeverstärker 4 von der Auswerte- und Steuereinheit 1 ein Stellsignal zuführbar, mit dem die Ansteuerung des Sendeverstärkers 4 durch das vom Digital-Analog-Wandler 3 abgegebene Signal während der Prüfzyklen unterbunden wird.

Die Schaltungsanordnung funktioniert wie folgt. Während der nicht zum Senden von Daten benötigten Zeitschlitze, d. h. während der Sendepausen werden zur Bestimmung des Offsets des Digital-Analog-Wandlers 3 über den die Leisung des Sendeverstärkers gesteuert wird, Kalibrierzyklen durchgeführt. Dazu werden in einem Signalgenerator 2, der auf vorteilhafte Weise auch in Form eines in einem Mikroprozessor implementierten Programms realisiert sein kann, auf ein entsprechendes Kommando der Auswerte- und Steuereinheit 1 hin Prüfsignale erzeugt und an den Digital-Analog-Wandler 3 angelegt. Bei diesen Prüfsignalen handelt es sich im einfachsten Fall um quasistatische Signale, es sind aber auch andere Signalformen realisierbar. Das Ausgangssignal des Digital-Analog-Wandlers 3, das im Sendebetrieb der Steuerung der Leistung des Sendeverstärkers 4 dient, wird über einen Analog-Digital-Wandler 6 in ein digitales Signal umgesetzt und der Auswerte- und Steuereinheit 1 zugeführt. Dort wird das vom Digital-Analog-Wandler 3 abgegebene, nach Umsetzung durch den Analog-Digital-Wandler 6 in digitaler Form vorliegende Signal mit dem vom Signalgenerator 2 abgegebenen digitalen Signal zur Ansteuerung des Digital-Analog-Wandlers 3 verglichen. Aus dem Vergleich der beiden Signale wird der Offset des Digital-Analog-Wandlers bestimmt. Dieser wird dem Signal zur Ansteuerung des Digital-Analog-Wandlers 3 beim nächsten Sendevorgang als Korrekturwert additiv überlagert und somit der Offset des Digital-Analog-Wandlers kompensiert.

Aus Gründen der Frequenzökonomie sowie zur Reduzierung des Energiebedarfs der Mobilfunk-Telefone ist vorgesehen, die Sendeleistung nur während der zum Senden benötigten Zeitschlitze auf einen vorgegebenen Wert anzuheben und während der Sendepausen abzusenken. Um den damit verbundenen Energiespareffekt auch mit dem erfindungsgemäßen Verfahren realisieren zu können, kann es vorgesehen sein, die Verbindung zwischen Digital-Analog-Wandler 3 und Sendeverstärker 4 für die Dauer des Kalibrierzyklus zu unterbrechen. Dies kann auf einfache Weise durch einen in die Verbindung zwischen Digital-Analog-Wandler 3 und Sendeverstärker 4 eingeschleiften steuerbaren Schalter erreicht werden, der durch die Auswerte- und Steuereinheit 1 zu Beginn eines Kalibrierzyklus geöffnet, zu Beginn eines Sendevorgangs wieder geschlossen wird.

Gemäß einer Weiterbildung der Erfindung ist es vorgesehen, das vom Digital-Analog-Wandler 3 während einer Sendepause abgegebene Signal vor einer Umsetzung in ein digitales Signal durch einen Verstärker 5 zu verstärken, wobei davon ausgegangen wird, daß der Verstärker einen geringen Offset besitzt. Auf diese Weise wird erreicht, daß der vom Analog-Digital-Wandler 6 verursachte, dem eigentlich zu bestimmenden Signal überlagerte Offset vernachlässigbar klein ist. Zudem ist es bei kleinen Werten des Ausgangssignals des Digital-Analog-Wandlers 3 möglich, die Auflösung bei der Erfassung und Auswertung des Signals zu verbessern, wozu dem Verstärker 5 von der Auswerte- und Steuereinheit 1 ein Stellsignal zur Einstellung des Verstärkungsfaktors zuführbar ist.

Bei einer weiteren Ausführungsform der Erfindung ist vorgesehen, daß der vom Verstärker 5 verursachte Offset in der Auswerte- und Steuereinheit 1 bekannt ist und bei der Bestimmung des Offsets des Digital-Analog-Wandlers 3 in Form eines Korrekturwertes berücksichtigt wird. Ähnliches gilt auch für den Analog-Digital-Wandler 6 zur Umwandlung des Ausgangssignals des Digital-Analog-Wandlers 3 in ein digitales Signal. Auch hier kann aus der Kenntnis des Offsets des Analog-Digital-Wandlers 6 das zu erfassende Signal um den durch den A/D-Wandler verursachten Offset bereinigt werden.

Schließlich sieht eine Weiterbildung der Erfindung vor, daß für den Fall, daß der Offset des D/A-Wandlers 3 im wesentlichen von der Umgebungstemperatur abhängig ist, der Offset als Maß für die Temperatur zur Kompensation des Temperaturgangs weiterer Bauelemente verwendet wird.

## Patentansprüche

1. Verfahren zur Steuerung der Leistung eines Sendeverstärkers eines Funkgeräts, insbesondere des Sendeverstärkers eines Mobilfunk-Telefons, über einen Digital-Analog-Wandler,
**dadurch gekennzeichnet,**
**daß** während Sendepausen Kalibrierzyklen für den Digital-Analog-Wandler durchgeführt werden,
**daß** in einem Signalgenerator (2) Prüfsignale erzeugt und an den Digital-Analog-Wandler (3) angelegt werden,
**daß** die vom Digital-Analog-Wandler (3) ausgegebenen Signale über einen Analog-Digital-Wandler (6) in eine Auswerte- und Steuereinheit(1) eingelesen werden,
**daß** in der Auswerte- und Steuereinheit (1) durch Vergleich der im Signalgenerator (2) erzeugten Prüfsignale mit den über den Analog-Digital-Wandler (6) eingelesenen Signalen der Offset des Digital-Analog-Wandlers (3) bestimmt wird,
und **daß** beim nächsten Sendevorgang der ermittelte Offset dem dem Digital-Analog-Wandler (3) zugeführten Signal überlagert wird.

2. Verfahren nach Anspruch 1,
**dadurch gekennzeichnet,**
**daß** das vom Digital-Analog-Wandler (3) abgegebene Signal vor dem Einlesen in die Auswerte- und Steuereinheit (1) durch einen Verstärker (5) verstärkt wird.

3. Verfahren nach Anspruche 2,
**dadurch gekennzeichnet,**
**daß** der Offset des Verstärkers (5) in der Auswerte- und Steuereinheit (1) bekannt ist, und das eingelesene Signal um den durch den Verstärker (5) bedingten Offset bereinigt wird.

4. Verfahren nach einem der Ansprüche 1 bis 3,
**dadurch gekennzeichnet,**
**daß** der Offset des Analog-Digital-Wandlers (6) in der Auswerte- und Steuereinheit (1) bekannt ist, und das eingelesene Signal um den Offset des Analog-Digital-Wandlers (6) bereinigt wird.

5. Verfahren nach einem der Ansprüche 1 bis 4,
**dadurch gekennzeichnet,**
**daß** als Prüfsignale quasistatische Signale verwendet werden.

6. Verfahren nach einem der Ansprüche 1 bis 5,
**dadurch gekennzeichnet,**
**daß** bei durch die Temperatur bestimmtem Offset des Digital-Analog-Wandlers (3) der Offset als Maß für die Temperatur verwendet wird,
und **daß** der Wert des Offsets für den Abgleich weiterer Komponenten verwendet wird.

## Claims

1. Method for controlling the power of an output amplifier of a transceiver, particularly the output amplifier of a mobile radio telephone, via a digital/analogue converter, **characterized in that** calibration cycles are carried out for the digital/analogue converter during transmission intervals,
**in that** test signals are generated in a signal generator (2) and applied to the digital/analogue converter (3),
**in that** the signals output by the digital/analogue converter (3) are read into an evaluating and control unit (1) via an analogue/digital converter (6),
**in that** the offset of the digital/analogue converter (3) is determined in the evaluating and control unit (1) by comparing the test signals generated in the signal generator (2) with the signals read in via the analogue/digital converter (6),
and **in that** during the next transmitting process, the offset found is superimposed on the signal supplied to the digital/analogue converter (3).

2. Method according to Claim 1, **characterized in that** the signal output by the digital/analogue converter (3) is amplified by an amplifier (5) before it is read into the evaluating and control unit (1).

3. Method according to Claim 2, **characterized in that** the offset of the amplifier (5) is known in the evaluating and control unit (1), and the signal read in is corrected by the offset of the amplifier (5).

4. Method according to one of Claims 1 to 3,
**characterized in that** the offset of the analogue/digital converter (6) is known in the evaluating and control unit (1), and the signal read in is corrected by the offset of the analogue/digital converter (6).

5. Method according to one of Claims 1 to 4,
**characterized in that** quasi-static signals are used as test signals.

6. Method according to one of Claims 1 to 5,
**characterized in that** when the offset of the digital/analogue converter (3) is determined by the temperature, the offset is used as a measure of the temperature,
and **in that** the value of the offset is used for calibrating other components.

## Revendications

1. Procédé de commande de la puissance d'un amplificateur d'émission d'un appareil radio notamment de l'amplificateur d'émission d'un téléphone mobile par un convertisseur numérique/analogique,
**caractérisé en ce que**
pendant les pauses d'émission on effectue des cycles de calibrage du convertisseur numérique/analogique,
- dans un générateur de signal (2) on génère des signaux de contrôle et on les applique au convertisseur numérique/analogique (3),
- les signaux émis par le convertisseur numérique/analogique (3) sont enregistrés par un convertisseur analogique/numérique (6) dans une unité de traitement et de commande (1),
- dans cette unité de traitement et de commande (1), par comparaison des signaux de contrôle générés dans générateur de signal (2) et des signaux enregistrés par le convertisseur analogique/numérique (6), on détermine le décalage du convertisseur numérique/analogique (3) et,
- lors de l'opération d'émission suivante, on combine le décalage déterminé au signal appliqué au convertisseur numérique/analogique (3).

2. Procédé selon la revendication 1,
**caractérisé en ce que**
le signal émis par le convertisseur numérique/analogique (3) est amplifié par un amplificateur (5) avant d'être enregistré dans l'unité de traitement et de commande (1).

3. Procédé selon la revendication 2,
**caractérisé en ce que**
le décalage de l'amplificateur (5) est connu dans l'unité de traitement et de commande (1) et le signal enregistré est nettoyé du décalage occasionné par l'amplificateur (5).

4. Procédé selon l'une quelconque des revendications 1 à 3,
**caractérisé en ce que**
le décalage du convertisseur analogique/numérique (6) de l'unité de traitement et de commande (1) est connu et le signal enregistré est nettoyé du décalage du convertisseur analogique/numérique (6).

5. Procédé selon l'une quelconque des revendications 1 à 4,
**caractérisé en ce que**
les signaux de contrôle sont des signaux quasi-statistiques.

6. Procédé selon l'une quelconque des revendications 1 à 5,
**caractérisé en ce que**
pour le décalage du convertisseur numérique/analogique (3) défini par le décalage de la température, on utilise le décalage comme mesure de la température et,
on utilise la valeur du décalage pour compenser d'autres composants.
